Europäisches Patentamt

European Patent Office

Office européen des brevets

(19)

(11) **EP 0 883 919 B1**

(12) **EUROPÄISCHE PATENTSCHRIFT**

(45) Veröffentlichungstag und Bekanntmachung des Hinweises auf die Patenterteilung:
**17.05.2000 Patentblatt 2000/20**

(21) Anmeldenummer: **97903341.2**

(22) Anmeldetag: **20.02.1997**

(51) Int Cl.[7]: **H01S 3/098**, H01S 5/10

(86) Internationale Anmeldenummer:
**PCT/EP97/00814**

(87) Internationale Veröffentlichungsnummer:
**WO 97/32373 (04.09.1997 Gazette 1997/38)**

(54) **VERFAHREN UND VORRICHTUNG ZUM BETRIEB EINER LASERDIODE**

METHOD AND DEVICE FOR OPERATING A LASER DIODE

PROCEDE ET DISPOSITIF POUR FAIRE FONCTIONNER UNE DIODE LASER

(84) Benannte Vertragsstaaten:
**DE ES FR GB IT**

(30) Priorität: **01.03.1996 DE 19607877**
**01.03.1996 DE 19607880**

(43) Veröffentlichungstag der Anmeldung:
**16.12.1998 Patentblatt 1998/51**

(73) Patentinhaber: **Agfa-Gevaert Aktiengesellschaft**
**51373 Leverkusen (DE)**

(72) Erfinder: **KAPPELER, Franz**
**D-82178 Puchheim (DE)**

(56) Entgegenhaltungen:
**EP-A- 0 568 897      DE-A- 3 442 188**

- **OPTICS LETTERS, Bd. 20, Nr. 7, 1.April 1995, Seiten 731-733, XP000497433 KIM I S ET AL: "COHERENCE-COLLAPSED 1.3- M MULTIMODE LASER DIODE FOR THE FIBER-OPTIC GYROSCOPE"**
- **IEE PROCEEDINGS J OPTOELECTRONICS, Bd. 137, Nr. 6, Dezember 1990, STEVENAGE GB, Seiten 385-390, XP002031557 J. WANG ET AL: "Noise characteristics of PCM modulated single mode semiconductor laser diodes with distant optical feedback"**
- **PATENT ABSTRACTS OF JAPAN vol. 005, no. 145 (E-074), 12.September 1981 & JP 56 080193 A (NIPPON TELEGR & TELEPH CORP), 1.Juli 1981,**
- **PATENT ABSTRACTS OF JAPAN vol. 008, no. 101 (P-273), 12.Mai 1984 & JP 59 011548 A (HITACHI SEISAKUSHO KK), 21.Januar 1984,**
- **JOURNAL OF LIGHTWAVE TECHNOLOGY, Bd. lt-4, Nr. 11, November 1986, NEW YORK US, Seiten 1655-1661, XP002031558 R.W. TKACH ET AL: "Regimes of feedback effects in 1.5 mum distributed feedback lasers" in der Anmeldung erwähnt**
- **IEEE JOURNAL OF SELECTED TOPICS IN QUANTUM ELECTRONICS, Bd. 1, Nr. 2, 1.Juni 1995, Seiten 480-489, XP000521110 PETERMANN K: "EXTERNAL OPTICAL FEEDBACK PHENOMENA IN SEMICONDUCTOR LASERS" in der Anmeldung erwähnt**

**Beschreibung**

Die Erfindung betrifft ein Verfahren und eine Vorrichtung zum Betrieb einer Laserdiode nach den Oberbegriffen der Ansprüche 1 und 13.

Laserdioden werden in vielen Bereichen der Informationsübertragung eingesetzt. Sie eignen sich hervorragend dafür, den erzeugten Laserstrahl hinsichtlich seiner Intensität zu modulieren. Aufgrund der geringen Baugröße und der leicht zu realisierenden, elektronischen Ansteuerbarkeit von Laserdioden sind mit ihnen sehr hohe Datenübertragungsraten erzielbar. Dies ist sowohl bei der Nachrichtenübertragung als auch bei der Wiedergabe von Informationen besonders vorteilhaft.

Eine Problematik, die bei Laserdioden besteht, ist jedoch ihre Eigenschaft in bestimmten Intensitätsbereichen zwischen verschiedenen Moden spontan zu wechseln. Dieser Effekt verursacht niederfrequente Intensitätsschwankungen. Er wird als "Mode hopping" bezeichnet. Er stört bei der Anwendung von Laserdioden, wenn zwischen verschiedenen Helligkeiten statistisch oder dynamisch umgeschalten werden soll, insbesondere bei einer Signalmodulation.

Zur Verhinderung von Mode hops sind in der Vergangenheit bereits eine Reihe von Löschungsvorschlägen bekannt geworden. In der US 4,817,098 ist beispielsweise ein Regelungssystem vorgeschlagen, mit dem die Laserleistung mittels verschiedener Maßnahmen konstantgehalten wird. Dort wurde zum einen vorgeschlagen, die Temperatur der Laserdiode zu messen, um Mode hops zu vermeiden. Zum anderen wurde versucht, durch Temperaturregelung der Laserdiode Temperaturschwankungen möglichst gering zu halten und damit eine möglichst gleichmäßige Leistung der Laserdiode zu erreichen.

In der US-PS 5,283,793 wurde vorgeschlagen, einem Bildsignal bei der Aufzeichnung auf ein Aufzeichnungsmaterial ein Hochfrequenz-Signal zu überlagern.

Schließlich wurde in der US-PS 4,799,069 und in der US-PS 5,386,124 vorgeschlagen, die Laserdiode jeweils zwischen zwei Bildpunkt-Signalen kurz auszuschalten, um Mode hops zu vermeiden.

Die genannten Versuche, Mode hops zu vermeiden, sind entweder technisch relativ aufwendig oder führen zu relativ unbefriedigenden Ergebnissen. Es ist daher Aufgabe der Erfindung, ein Verfahren und eine Vorrichtung anzugeben, mit denen plötzliche, durch Mode hops verursachte, niederfrequente Störungen der Laser-Strahlintensität vermieden werden. Es ist besonders eine Aufgabe der Erfindung, das Licht einer Laserdiode während des Abtastens einer Nutzfläche hinsichtlich Mode hops zu stabilisieren, wenn durch die Nutzfläche Störreflexe auf die Laserdiode rückwirken.

Diese Aufgabe wird gelöst durch die in den Ansprüchen 1 und 13 beschriebene Erfindung. Vorteilhafte Ausführungsformen der Erfindung sind Gegenstand der Unteransprüche.

Die Erfindung beruht auf der Erkenntnis, daß Modensprünge (Mode hops) dadurch vermieden werden können, daß innerhalb der Laserdiode möglichst viele verschiedene Moden gleichzeitig angeregt werden. Dies führt zu einem hochfrequenten Rauschen, während das niederfrequente, durch Mode hops verursachte Rauschen unterdrückt wird.

Erfindungsgemäß ist deshalb vorgesehen, das aus einer Laserdiode austretende Licht über ein zeitlich und bezüglich der Laserdiode räumlich stabiles optisches Element zumindest teilweise wieder in die aktive Zone der Laserdiode zurückzukoppeln, so daß sich die Laserdiode im Zustand eines Kohärenzkollapses befindet. Zu diesem Zweck wird z.B. ein geringer Teil des aus der Laserdiode austretenden Lichts an einem externen Spiegel reflektiert und mittels einer geeigneten Optik wieder in den Laserresonator zurückgeführt. Die Rückkopplung erfolgt über einen zusätzlichen, zweiten Strahlengang. Dieser Strahlengang kann vom Nutzstrahlengang zumindest teilweise optisch getrennt sein. Die Lichtaustrittsfläche der Laserdiode bildet mit dem Rückkoppelglied einen externen Resonator, dessen Länge wesentlich größer als die Resonatorlänge der Laserdiode ist. Dementsprechend ist der Abstand der Resonanzfrequenzen (= Moden) des externen Resonators wesentlich kleiner als derjenige des Laserresonators. Beispielsweise liegen die Modenabstände bei 500MHz für einen 30 cm langen externen Resonator bzw. bei 170 GHz für eine 0,2 mm lange GaAlAs-Laserdiode.

Der in die Laserdiode über den Nutzstrahlengang zurückgekoppelte Lichtstrahl weist stets geringfügige Schwankungen hinsichtlich seiner Amplitude und Phasenlage auf, die sowohl durch das optische Rauschen (spontane Emission) der Laserdiode selbst als auch durch zeitlich veränderliche optische Reflexe von beweglichen Teilen (Schwingspiegel, Film) hervorgerufen werden.

Wenn nun die Leistung des gezielt im zweiten Strahlengang rückgekoppelten Lichtes einen bestimmten Mindestwert überschreitet, werden diese Amplituden- und Phasenschwankungen in der aktiven Zone der Laserdiode so weit verstärkt, daß eine statistische Eigenmodulation der Lichtleistung (AM) und der Laserfrequenz (FM) auftritt. Die Periode T dieser Eigenmodulation wird durch die Laufzeit $2\,L_{extern}/c$ der Lichtwelle im zusätzlichen externen Resonator bestimmt, wobei $L_{extern}$ die Länge des externen Resonators und c die Lichtgeschwindigkeit bezeichnen. Der Kehrwert dieser Periode ist aber gerade der Frequenzabstand df der externen Resonatormoden:

$$df = 1/T = c/(2 \cdot L_{extern}); \quad c = 3 \cdot 10^{10} \text{ cm/s.}$$

Durch diese kombinierte AM-FM-Eigenmodulation wird eine große Anzahl von Seitenbändern erzeugt, die genau mit den Moden des externen Resonators zusammenfallen. Auf diese Weise wird erreicht, daß in dem Laser-System, bestehend aus Laserdiode und zusätzlichem externem Resonator, gleichzeitig eine große Anzahl von externen Resonatormoden angeregt wird. Dies hat zur Folge, daß sich die emittierte Laserenergie gleichmäßig auf eine große Anzahl von Moden verteilt und im zeitlichen Mittel sehr konstant bleibt.

Ein erfindungsgemäß gezielt herbeigeführter und zeitlich stabil aufrecht erhaltener Effekt besteht darin, daß durch die große Modenzahl die Kohärenzlänge der erzeugten Strahlung stark reduziert wird. Dieser Betriebszustand der Laserdiode wird als Kohärenzkollaps bezeichnet, weil die Laserstrahlung bei Überschreiten eines kritischen Grenzwertes für die rückgekoppelte Lichtleistung abrupt von einem Zustand hoher Kohärenz (Monomode-Betrieb mit statistisch auftretenden Modensprüngen) in einen Zustand geringer Kohärenz (Multimode-Betrieb ohne Modensprünge) übergeht.

In Systemen, denen das Ziel zugrundeliegt, die Frequenz des Laserlichts zu stabilisieren, kommt es bei einer optischen Rückkopplung darauf an, daß die optische Weglänge der Rückkopplung kleiner oder maximal gleich der Kohärenzlänge des Laserlichts ist. Solche Systeme sind beispielsweise in der DE 34 42 188 A1 und in der DE 34 10 729 A1 beschrieben. Im Unterschied zu derartigen Systemen geht in dem erfindungsgemäßen System, bei dem Kohärenzkollaps auftritt, die Rückkopplung damit einher, daß die Länge des Rückkopplungsweges größer ist als die Kohärenzlänge des Lichts; die Rückkopplung in einem derartigen System wird daher als inkohärent bezeichnet.

Die für den Kohärenzkollaps benötigte optische Rückkoppel-Leistung hängt von den Eigenschaften der Laserdiode und dem Reflexionsgrad des externen Resonators ab und liegt in der Größenordnung von einigen Prozent der emittierten Leistung. In R.W. Tkach, Regimes of Feedback Effects in 1,5 um Distributed Feedback Lasers, Journal of lightware Technology, Vol. LT-4, No. 11, November 1986, pages 1655-1661 sowie in K. Petermann, Laserdiode Modulation and Noise, Kluwer Academic Publishers, Dordrecht (NL), 1988 pages 251 - 290 sind Untersuchungen zu Laserdioden im Betriebszustand des Kohärenzkollapses beschrieben sowie Werte für den geeigneten Reflexionsgrad angegeben. In K. Petermann, Extemal Optical Feedback Phenomena in Semiconductor Lasers, IEEE Journal of Selected Topics in Quantum Electronics, Vol. 1, No.2, June 1996, pages 480 - 489 sind weitere Untersuchungen zu Laserdioden im Betriebsbereich des Kohärenzkollapses beschrieben.

Die Erfindung läßt sich besonders vorteilhaft bei sogenannten Monomode-Lasem anwenden, deren interner Resonator normalerweise nur Licht einer einzigen Wellenlänge erzeugt. Derartige Monomode-Laser zeigen in der Regel bei Veränderung der Stromstärke an bestimmten Stellen abrupte Modensprünge, d. h. die Lasertätigkeit springt von einer Mode in eine benachbarte andere. Dabei springt in der Regel auch die erzeugte Lichtleistung auf einen anderen Wert. Erfindungsgemäß wurde erkannt, daß sich durch gezieltes Herbeiführen eines Kohärenzkollapses die Lichtleistung im niederfrequenten Bereich wesentlich besser konstant halten läßt als im Monomode-Betrieb. Außerdem wird die Laserstrahlung unempfindlich gegen ungewollte optische Reflexe von anderen Teilen des optischen Gerätes.

Modensprünge lassen sich in interne und externe Modensprünge klassifizieren. Die internen Modensprünge bei Monomode-Lasem werden durch die innere Struktur des Lasers beeinflußt. Beispielsweise entstehen bei einem Distributed Bragg Reflector (DBR)-Laser die internen Modensprünge durch die interne Resonator-Struktur. Der Brechungsindex des laseraktiven Halbleitermaterials ändert sich sowohl mit der Temperatur der Laserdiode als auch mit der Stromstärke. Überschreiten Temperatur und/oder Stromstärke bestimmte Schwellwerte, so ändert sich die Resonanzfrequenz derart stark, daß ein Modensprung entsteht. Diese Sprünge liegen in einem sehr hohen Frequenzbereich von typisch einigen hundert Gigahertz (GHz). Hinzu kommt bei derartigen Laserdioden, daß sich auch die Verstärkungskurve des internen Resonators, d. h. der Grad der über die Wellenlänge aufgetragene Verstärkung mit der Temperatur der Laserdiode verschiebt. Diese Effekte tragen wesentlich zu Modensprüngen von Monomode-Lasem bei.

Die externen Modensprünge sind durch externe, d. h. außerhalb des inneren Resonators der Laserdiode bedingt. Derartige Effekte treten z. B. auf, wenn sich in einem Laserstrahldrucker kurzzeitig eine reflektierende Fläche (z. B. von einem Aufzeichnungsblatt) in den Strahlengang des Lasers schiebt und Licht in die Laserdiode zurückreflektiert. Anders ausgedrückt, bildet sich dabei kurzzeitig ein externer Resonator, der auf die Gesamt-Lichtleistung des Lasers wirkt und zu Modensprüngen führt.

Beide oben genannten Arten von Modensprüngen werden durch die gezielte Herbeiführung eines Kohärenzkollapses unterdrückt.

Erfindungsgemäß kann die Rückkopplung des Lichtes in die Laserdiode z. B. durch faseroptische oder reflektierende optische Mittel erfolgen. Zum Erreichen einer inkohärenten Rückkopplung ist es vorteilhaft, wenn die optische Weglänge des rückgekoppelten Lichtes, d. h. die Länge des äußeren Resonators bzw. die Länge des zweiten optischen Weges wesentlich größer ist als die Kohärenzlänge des Lichts. Besonders vorteilhaft ist es, wenn diese optische Weglänge mindestens 100 mm beträgt. Weiterhin ist es vorteilhaft, wenn zumindest 0,01 % der aus der Laserdiode austretenden Lichtleistung in die Diode zurückgekoppelt wird. Bei einer Rückkopplung von 0,1 % bis 1 % des ausgetretenen Lichts ist ein Kohärenzkollaps sicher erreichbar. Ein drittes, die Wirksamkeit der Rückkopplung beeinflussendes Kriterium ist der Grad der Überdeckung der aktiven Zone in der Laserdiode mit dem rückgekoppelten Licht. Es hat sich gezeigt, daß der Kohärenzkollaps in der Laserdiode dann besonders groß ist, wenn die Querschnittfläche des emittierten Strahls und die Querschnittsfläche des reflektierten Strahls sich am Laserspiegel zu mindestens 50 % überlappen. Eine derartige Anordnung führt dann dazu, daß der interne Rückkopplungsfaktor, d. h. der Anteil derjenigen Lichtintensität, der in die aktiven Zone der Laserdiode zurückgekoppelt wird zwischen $10^{-5}$ und 1 % liegt, wodurch ein Kohärenzkollaps in der Laserdiode erreicht wird.

Nachfolgend wird die Erfindung anhand mehrerer Ausführungsbeispiele und Figuren näher erläutert. Jeweils gleichartige Elemente der verschiedenen Ausführungsbeispiele tragen dabei jeweils dieselben Bezugsziffern.

Es zeigen:

Fig. 1      eine Prinzip-Darstellung für ein Laser-Bildaufzeichnungsgerät,

Fig. 2      verschiedene Varianten für Laser-Rückkopplungsanordnungen,

Fig. 3      detailliertere Darstellungen für Laser-Rückkopplungen,

Fig. 4      eine doppelseitige Laserstrahlanordnung,

Fig. 5      eine Rückkoppelanordnung mit Lichtwellenleitern,

Fig. 6      Details einer Laserdiode,

Fig. 7      verschiedene Moden-Spektren,

Fig. 8      zwei Rauschspektren,

Fig. 9      eine Schaltung zur Rauschmodulation einer Laserdiode und

Fig. 10     einen Vergleich der Wirkungen eines Kohärenzkollapses und einer Rauschmodulation.

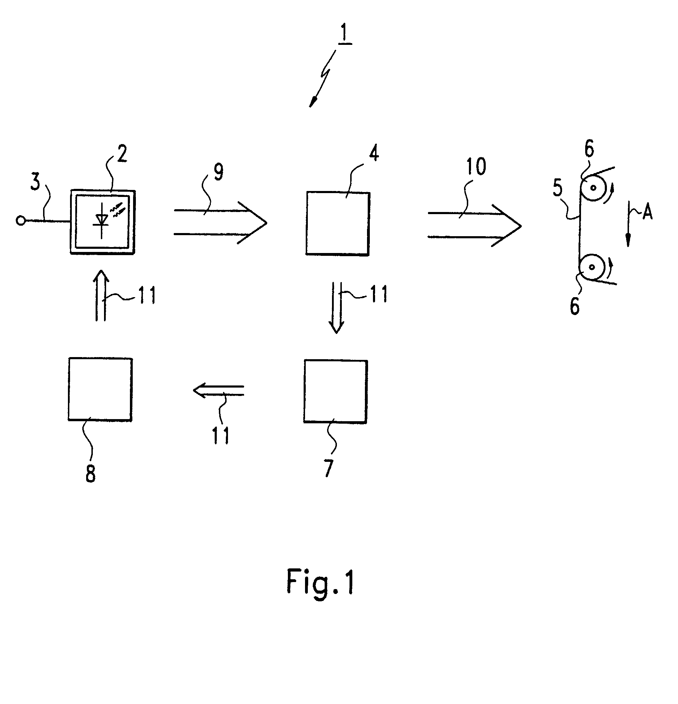

In Fig. 1 ist die prinzipielle Funktionsweise der Erfindung am Beispiel eines Laser-Bildaufzeichnungsgeräts 1 dargestellt. Eine Laserdiode 2 wird über eine Bildsignalleitung 3 mit Graustufen-Bildsignalen angesteuert. Sie erzeugt einen entsprechend dem Bildsignal intensitätsmodulierten Laserstrahl 9, der eine zeitlich modulierte Leistung $P_A$ (t) hat. Die Bildsignale können z. B. von einem Bildvorlagen-Scanner auf CCD-Basis oder auch von einem medizinischen Diagnosegerät wie einem CT, NMR oder Ultraschall-Diagnosegerät stammen. Dieser Austrittsstrahl 9 wird innerhalb einer Auskoppeloptik 4 in einen Nutzstrahl 10 mit einer Leistung $P_{nutz}$ und einen Rückkoppel-Strahl 11 mit einer Leistung $P_{rück}$ aufgeteilt. Der Nutzstrahl 10 trifft, nachdem er von einer nicht näher gezeigten Ablenkvorrichtung wie einem Polygon- oder Schwingspiegel in an sich bekannter Weise periodisch abgelenkt wurde, auf einen Aufzeichnungsträger 5 auf. Der Träger 5 kann z. B. eine Phosphor-Speicherfolie sein oder ein über Transportrollen 6 in Richtung A angetriebener fotografischer Film. Für diese Anwendungszwecke sind Laserdioden mit relativ hohen Leistungen von ca. 100 mW oder höher erforderlich.

Bei der in Fig. 1 gezeigten Anordnung wird der Rückkoppelstrahl 11 über eine Rückführungsoptik 7 zu einer Einkoppeloptik 8 weitergeleitet, die den Rückkoppelstrahl 11 gezielt in die aktive Zone der Laserdiode 2 wieder einkoppelt. Die Rückführungsoptik 7 ist dazu zeitlich und bezüglich der Laserdiode 2 räumlich stabil auf einem Trägerelement angeordnet.

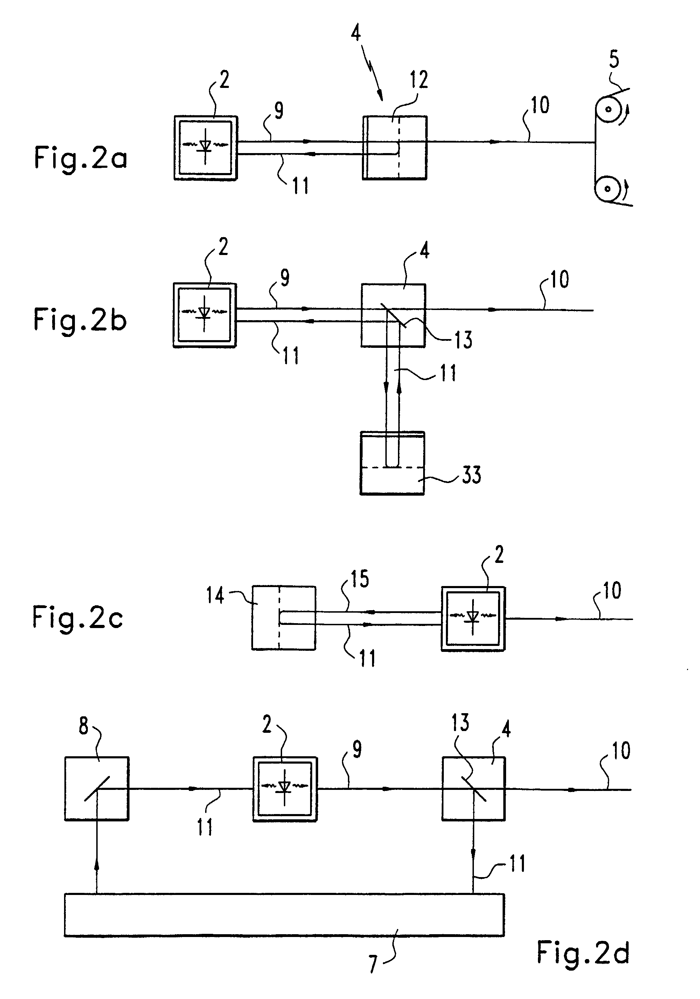

Fig. 2 zeigt verschiedene Varianten für die Rückkopplung. Während bei den in den Figuren 2a und 2b dargestellten Varianten der rückgekoppelte Strahl 11 zumindest teilweise denselben optischen Weg bzw. dieselben optischen Komponenten durchläuft wie der Austrittsstrahl 9, wird bei den in Figuren 2c und 2d dargestellten Varianten der rückgekoppelte Strahl 11 über einen getrennten optischen Weg bzw. mit separaten optischen Elementen in die aktive Zone der Laserdiode 2 zurückgekoppelt.

Den in Figuren 2a, 2b und 2d dargestellten Ausführungsformen ist wiederum gemeinsam, daß die Auskoppeloptik 4 ein teilweise reflektierendes Element enthält.

In Fig. 2a besteht das teilweise reflektierende Element aus einer transmittierenden Reflexionsoptik 12. Sie reflektiert einen vorgegebenen Teil der einfallenden Lichtleistung des Austrittsstrahls 9 auf der optischen Achse oder zumindest so, daß der zurückreflektierte Strahl 11 parallel zum Austrittsstrahl 9 auf oder zumindest nahe an der optischen Achse verläuft.

Bei dem in Fig. 2b dargestellten Ausführungsbeispiel wird der rückgekoppelte Strahl 11 von einem teildurchlässigen, schräg zur optischen Achse stehenden Spiegel 13 auf einen Total-Reflexionsspiegel 33 gerichtet. Von dort wird er auf oder nahe der optischen Achse über den teildurchlässigen Spiegel 13 wieder zurück in die Laserdiode 2 reflektiert. Der optische Weg des rückgekoppelten Strahls 11 und damit die äußere Resonatorlänge der gesamten Laser-Anordnung ist dadurch wesentlich größer als bei dem in Fig. 2a gezeigten Ausführungsbeispiel.

Bei der in Fig. 2c gezeigten Ausführungsform wird aus dem internen Laser-Resonator der Laserdiode 2 sowohl an dessen Vorderseite als auch an dessen Rückseite, d. h. an beiden begrenzenden Spiegeln des internen Resonators Licht ausgekoppelt. Der auf der Vorderseite des internen Resonators austretende Strahl 10 wird vollständig als Nutzstrahl für die gewünschte Anwendung (z. B. einer Bildaufzeichnung) genutzt. Der auf der Rückseite des internen Resonators austretende Laserstrahl 15 wird dagegen an einem Reflexionsspiegel 14 total reflektiert und als rückgekoppelter Strahl 11 durch den rückwärtigen Spiegel des internen Resonators wieder in die aktive Zone der Laserdiode 2 eingekoppelt. Dieses Ausführungsbeispiel setzt voraus, daß beide Resonator-Spiegel der Laserdiode einen Reflexionskoeffizient kleiner als 1 aufweisen.

Die Länge des externen Resonators ergibt sich hier aus der optischen Weglänge zwischen dem rückwärtigen Resonatorspiegel der Laserdiode 2 und dem Totalreflexionsspiegel 14.

Ein weiteres Ausführungsbeispiel für eine geeignete Rückkoppel-Anordnung ist in Fig. 2d dargestellt. Bei dieser Anordnung wird wiederum nur ein Laserstrahl 9 aus der Laserdiode 2 ausgekoppelt. Dieser Laserstrahl 9 wird wiederum in einer Auskoppeloptik 4 mittels eines halbdurchlässigen Spiegels 13 in einen Nutzstrahl 10 und einen Rückkoppelstrahl 11 zerlegt. Der Rückkoppelstrahl 11 wird hier in die Rückführungsoptik 7 eingekoppelt. Diese Rückführungsoptik 7 kann sowohl lichtbrechende Elemente als auch reflektierende Systeme oder auch faseroptische Elemente enthalten. Durch die Rückführungsoptik 7 wird der rückgekoppelte Strahl 11 in die Einkoppeloptik 8, welche beispielsweise ein Linsensystem aufweist, übertragen. Mit diesem Linsensystem wird der rückgekoppelte Strahl 11 auf den rückseitigen Spiegel des Resonators der Laserdiode 2 fokussiert und damit der rückgekoppelte Strahl 11 in die aktive Zone der Laserdiode 2 eingekoppelt.

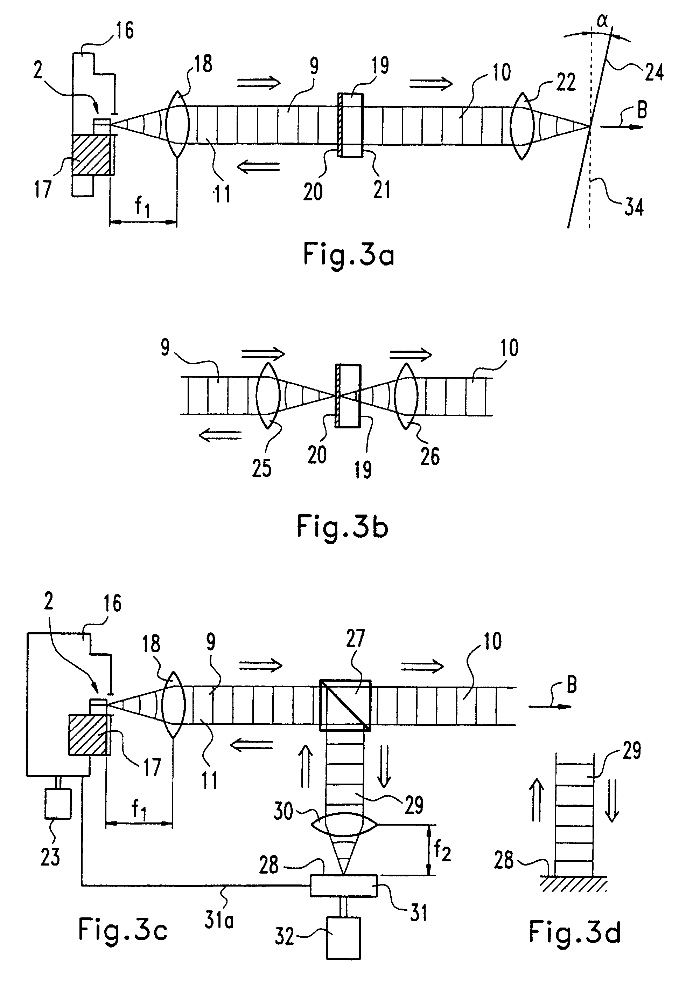

Fig. 3 zeigt genauere Details für eine geeignete Strahlrückkopplung zur Erzeugung des Kohärenzkollapses innerhalb der Laserdiode 2. Die Laserdiode 2 befindet sich hier auf einem Laserträger 17 (Wärmesenke) innerhalb eines Lasermoduls 16. Durch ein Austrittsfenster des Lasermoduls 16 tritt der in der Laserdiode 2 erzeugte Laserstrahl 9 aus. Dieser divergente Laserstrahl 9 wird mit einer Sammellinse 18, deren Brennpunkt genau mit dem Auskopplungsspiegel des internen Resonators der Laserdiode 2 zusammenfällt, zu einem parallelen Strahlenbündel geformt. Die Brennweite der Sammellinse 1 ist mit $f_1$ bezeichnet. Das parallele Strahlenbündel 9 trifft auf einen teilreflektierenden Planspiegel 19 auf. Die Eintrittsfläche 20 des Planspiegels 19 ist dazu dielektrisch beschichtet, so daß zwischen 1 % und 20 % vorzugsweise etwa 5 % der auftreffenden Strahlung des Lichtbündels 9 in sich selbst zurückreflektiert werden. Der zurückreflektierte Anteil bildet wiederum den rückgekoppelten Strahl 11. Die Austrittsfläche 21 des Planspiegels 19 ist für den für die Laserdiode 2 charakterisierenden Wellenlängenbereich, d. h. für alle ihre möglichen Moden-Wellenlängen, entspiegelt. Der aus dem Planspiegel 19 austretende parallele Nutzstrahl 10 wird über eine weitere Sammellinse 22 wiederum fokussiert. Im Fokus dieser Linse liegt der Aufzeichnungsträger, auf dem die aufzuzeichnende Information wiedergegeben werden soll. Der Aufzeichnungsträger ist in einer Ebene 24 angeordnet, die gegenüber einer zur optischen Achse B senkrechten Ebene 34 um einen Verkippungswinkel α geneigt ist. Diese Verkippung bewirkt, daß vom Aufzeichnungsträger (z. B. Film) wesentlich weniger Licht über die optische Achse in die aktive Zone der Laserdiode 2 zurückgekoppelt wird. Derartige, insbesondere bei einem relativ zu den optischen Komponenten bewegten Aufzeichnungsmedium, zufälligen Rückreflexionen haben sich als äußerst störend für die Aufzeichnungsqualität erwiesen. Bei der vorliegenden Erfindung wird deshalb statt derartiger, zufälliger Rückreflexionen eine gezielte, kontrollierbare Rückreflexion ausgewählter Strahlungskomponenten in die aktive Zone der Laserdiode bewerkstelligt.

In Fig. 3b ist eine fokussierende Anordnung dargestellt. Sie kann in einer Anordnung gemäß Fig. 3a statt des dort gezeigten afokalen Systems im Bereich des Spiegels 19 verwendet werden. Bei dieser Anordnung ist jeweils eine Linse 25 bzw. 26 vor- bzw. hinter dem teilreflektieren Planspiegel 19 geschaltet. Die Linsenanordnungen und ihre Brennweiten sind so gewählt, daß ihr jeweiliger Fokus genau auf der teilreflektierenden Eintrittsfläche 20 des Planspiegels 19 liegen.

Bei der in Fig. 3a gezeigten Anordnung muß der teilreflektierende Spiegel 19 genau senkrecht zur optische Achse B liegen, um eine ausreichende Rückkopplung des Strahls 11 in die aktive Zone der Laserdiode 2 zu gewährleisten. Bei der Anordnung gemäß Fig. 3b ist dagegen die Justage des teilreflektierenden Spiegels bezüglich der optischen Achse B relativ unkritisch. Aufgrund der Fokal-Bedingung für die beiden Linsen 25, 26 bezüglich der Reflexionsfläche 20 liegt der rückreflektierte Strahl 11 auch dann noch genau in der optischen Achse $B_1$ wenn der teilreflektierende Spiegel 19 nicht exakt senkrecht zur optischen Achse B liegt.

In Fig. 3c ist ein weiter verbessertes Ausführungsbeispiel für eine rückgekoppelte Laserdioden-Anordnung dargestellt. Von dem aus der Laserdiode 2 ausgetretenen Strahl 9 werden hier in einem Strahlteilerwürfel 27 etwa 10 % der Lichtleistung in einen Strahl 29 ausgekoppelt. Die übrigen 90 % der Lichtleistung des ausgetretenen Strahls 9 werden als Nutzstrahl 10 auf den Aufzeichnungsträger gerichtet. Der ausgekoppelte Strahl 29 trifft auf eine ebene Spiegelfläche 28. Diese Spiegelfläche 28 kann entweder ein total reflektierender Spiegel sein oder die teilweise reflektierende Einfallsfläche einer Fotodiode 31. Wird eine voll verspiegelte Fläche 28 verwendet, so kann der ausgekoppelte Strahl 29 voll zur Rückkopplung in die aktive Zone der Laserdiode 2 verwendet werden. Wird dagegen eine nur teilweise reflektierende Fotodiode verwendet, so kann der in die Fotodiode 31 eindringende Lichtanteil dazu verwendet werden, um über eine geeignete Signal-Rückführung 31a und eine entsprechende elektronische Regelung Leistungsschwankungen der Laserdiode 2 im Lasermodul 16 nachzuregeln. Diese Anordnung hat den weiteren Vorteil, daß anhand des Signals der Fotodiode 31 der Einsatz der niederfrequenten Rauschunterdrückung bzw. des Kohärenzkollapses festgestellt werden kann. Dieses Signal läßt sich dann vorteilhaft z. B. bei der Justierung der Anordnung und auch während der Belichtung einer Nutzfäche zur Funktionskontrolle der Laserdiode verwenden.

Der ausgekoppelte, afokale Strahl 29 wird über eine Sammellinse 30 auf die Spiegelfläche 28 fokussiert. Es hat sich als wichtig erwiesen, daß die Spiegelfläche 28 wiederum genau im Fokus der Linse 30 mit der Brennweite $f_2$ befindet.

Dadurch kann auch bei dieser Anordnung der ausgekoppelte Strahl 29 als Rückkopplungsstrahl 11 sehr genau in die Laserdiode 2 rückreflektiert werden.

Zur hochgenauen Justage der Laserdiode 2 in den Brennpunkt der Linse 18 ist bei diesem Ausführungsbeispiel vorgesehen, das Lasermodul 16 über ein verstellbares Element 23 verschiebbar zu lagern. Das Verstellelement ermöglicht sowohl Bewegungen entlang der optischen Achse B als auch in beiden Raumrichtungen senkrecht zur optischen Achse B.

In gleicher Weise ist auch der Reflexionsspiegel 31 mit einem x, y, z-Verstellelement 32 bezüglich der Linse 30 auf deren Brennpunkt justierbar. In einer gegenüber Fig. 3c vereinfachten Ausführungsform ist auf Linse 30 verzichtet und der ausgekoppelte Strahl 29 von einer senkrecht zu seiner Ausbreitungsrichtung stehenden Reflexionsfläche 28 in sich zurückreflektiert.

Als Verstellelemente 23, 32 eignen sich z. B. Schrittmotoren oder Aktoren auf Piezokristall-Basis. Über geeignete Regelschaltungen können ihre Positionen in bekannter Weise so nachgeregelt werden, daß die Flächen 28 und die Laserdiode 2 genau im Fokus der jeweils benachbarten Linse steht.

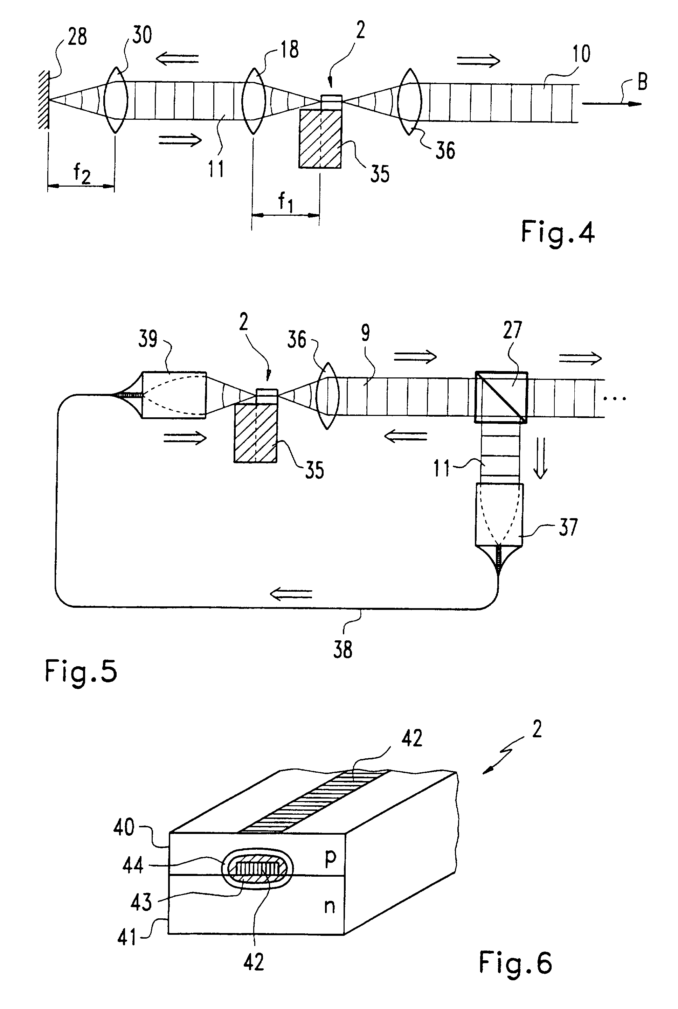

In Fig. 4 ist eine Anordnung dargestellt, bei der die Laserdiode 2 auf einem Träger 35 derart aufgebracht ist, daß die Laserdiode 2 an beiden Enden ihres optischen Resonators Licht emittieren kann. Bei diesem Chip-on-Carrier-System wird der Nutzstrahl 10 auf der einen Seite des Resonators und der Rückkoppel-Strahl 11 auf der anderen Seite des optischen Resonators der Laserdiode 2 entlang der optischen Achse B ausgekoppelt. Die Linse 18 sorgt für afokalen Strahlengang des ausgekoppelten Strahls 11, die Linse 30 fokussiert diesen Strahl auf eine genau im Fokus $f_2$ liegende Spiegelfläche 28. Diese Fläche 28 koppelt dann den Rückkoppel-Strahl 14 wieder in die aktive Zone der Laserdiode 2 ein, um den Kohärenzkollaps zu erzeugen. Auch bei diesem System kommt es maßgeblich darauf an, daß die aktive Zone bzw. der Auskoppelspiegel der Laserdiode 2 genau im Fokus $f_1$ der Linse 18 liegt. Mit einer Linse 36 wird der Nutzstrahl 10 parallelisiert, so daß dieser für den jeweils gewünschten Anwendungszweck, z. B. Bildaufzeichnung auf Film, zur Verfügung steht.

Fig. 5 zeigt ebenfalls ein Chip-on-Carrier-System, bei dem aber der rückgekoppelte Strahl 11 von dem aus der Laserdiode 2 ausgekoppelten Strahl 9 mittels eines Strahlteilerwürfels 27 ausgekoppelt wird. Der rückzukoppelnde Strahl 11 wird mittels eines Gradienten-Index-Stabes, einer sogenannten Grinrod-Linse 37 in einen faseroptischen Lichtleiter 38 eingekoppelt. Von dieser Glasfaser 38 wird er mittels einer zweiten Grinrod-Linse auf der Rückseite der Laserdiode 2 wieder in deren aktive Schicht eingekoppelt.

Fig. 6 zeigt maßgebliche Teile einer Laserdiode 2. Die Laserdiode besteht aus einer dotierten p-Halbleiterschicht 40 sowie aus einer dotierten n-Halbleiterschicht 41. Die Laseraktivität findet in der aktiven Zone 42 des p-n-Übergangs statt. Mindestens eine der beiden Endflächen des Laserkristalls weist eine Reflektivität < 100 % auf, so daß durch sie Licht aus der aktiven Zone 42 nach außen ausgekoppelt werden kann. Dies führt zu einer beugungsbedingten, emittierenden Lichtfläche 43 auf dem Laserspiegel. Bei der vorliegenden Erfindung wird in die aktive Fläche 42 Licht zurückgekoppelt, das aus dieser zuvor ausgetreten ist. Die Rückkopplung erfolgt vorzugsweise durch einen der beiden LaserSpiegel. Um einen vollständigen Kohärenzkollaps zu bekommen, ist es erforderlich, daß die rückgekoppelte Lichtfläche 44 die emittierende Lichtfläche 43 möglichst großflächig überdeckt. Ein Überdeckungsgrad von 50 bis 100 % hat sich dabei als günstig erwiesen.

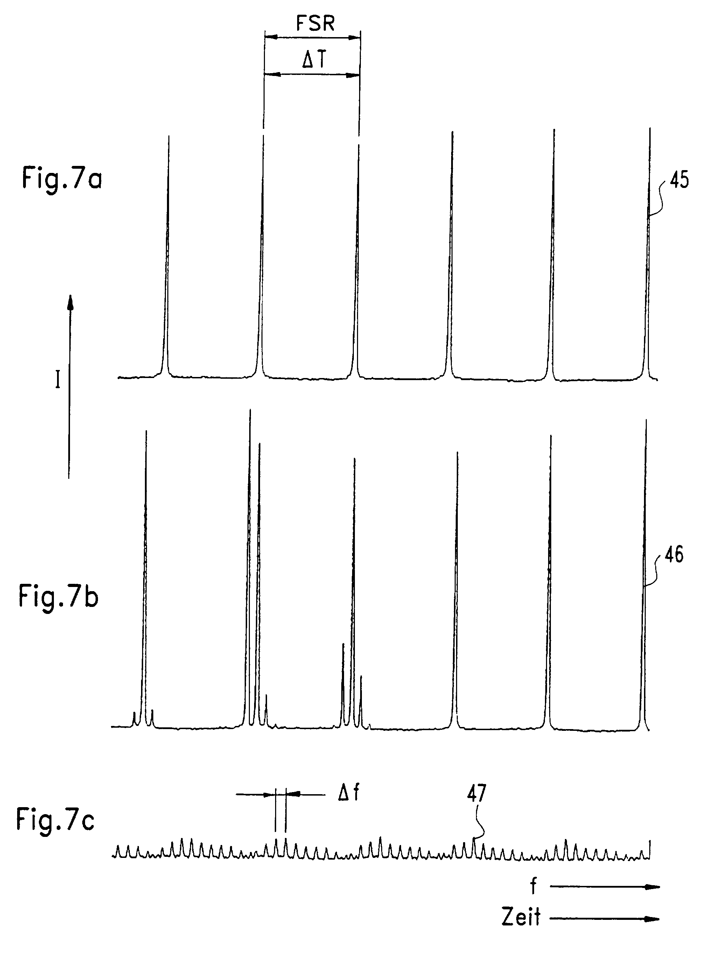

In Fig. 7 sind die Auswirkungen der vorliegenden Erfindung dargestellt, wie sie in Laboruntersuchungen nachgewiesen wurden. In den Figuren 7a, 7b und 7c sind Spektren 45, 46 und 47 dargestellt, die mit einem optischen Spektrumanalysator (Fabry-Perot-Interferometer) mit einem freien Spektralbereich (free spectral range, FSR) von 4,95 GHz gemessen wurden. Die Spektren stammen von einer distributed bragg reflection (DBR)-Monomode-Laserdiode. Die Art der Rückkopplung entsprach der in Fig. 3c dargestellten Anordnung. Die verschiedenen Spektren 45 und 46 wurden erzeugt, indem die Spiegelfläche 28 der Fig. 3 um 20 und 10 μm außerhalb des genauen Fokus der Linse 30 angeordnet wurden.

Das Fabry-Perot-Spektrometer wurde an der Stelle positioniert, an der normalerweise ein Film liegt. Gemäß Spektrum 45 erzeugte bei einer derartigen Anordnung die Laserdiode 2 genau eine Mode. Bei der vorliegenden Messung wurde das Fabry-Perot-Interferometer über ca. fünf freie Spektralbereiche gewobbelt. Dadurch wird die Monomode-Spektrallinie des DBR-Lasers fünfmal mit einem zeitlichen Abstand ΔT von ca. 8 ms dargestellt. Bei Annäherung der Spiegelfläche 28 an den genauen Fokuspunkt der Linse 30 ging das Spektrum 45 in das Spektrum 46 über, wobei leicht zu sehen ist, daß die Laserdiode Aktivität in drei verschiedenen Resonanz-Moden entwickelte.

Sobald die Spiegelfläche 28 genau im Fokus $f_2$ der Linse 30 ankam, schaltete die Lasertätigkeit auf einen Multimode-Modus um, d. h. der Kohärenzkollaps trat ein. Der Frequenzabstand Δf der verschiedenen Moden betrug dabei nur 525 MHz. Bei diesem Spektrum 47 war also die Laserleistung auf viele verschiedenen Moden verteilt.

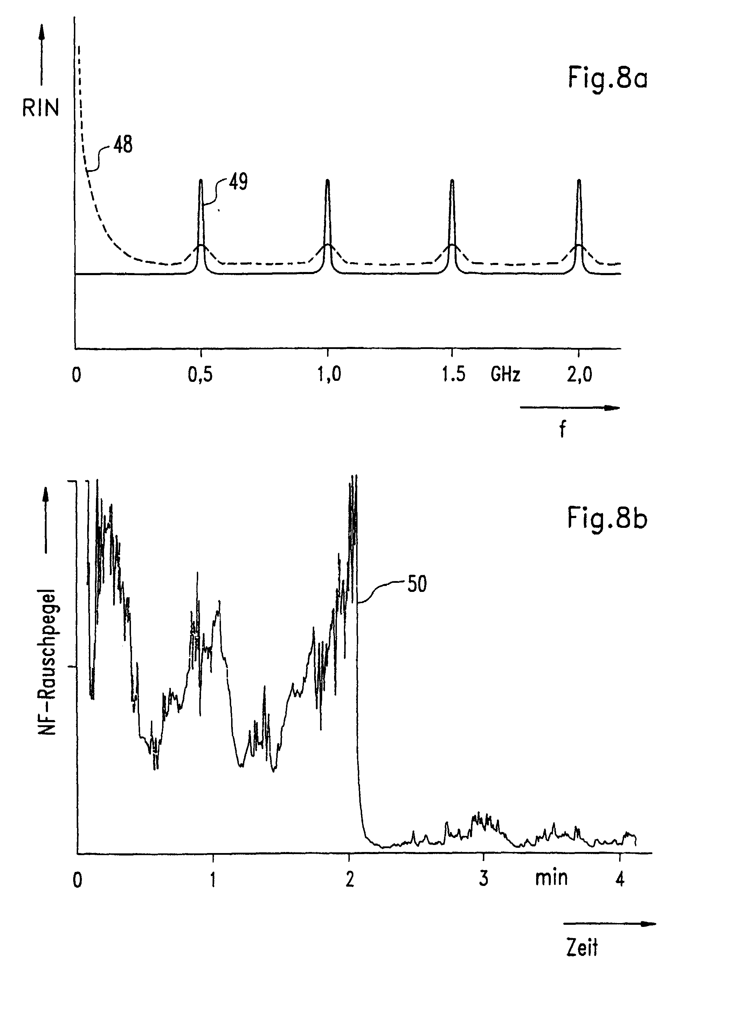

Fig. 8 zeigt die Auswirkungen der verschiedenen Moden-Spektren. In Fig. 8a sind zwei schematische Rauschspektren über der Frequenz f aufgetragen. Sie wurden mit der Anordnung gemäß 3c mit einer Fotodiode als Reflexionsspiegel 28 ermittelt. Das Spektrum 48 zeigt das Signal zu Rauschverhältnis (relative intensity noise) des gemessenen Spektrums (RIN), wenn Modenspringen auftritt. Das Spektrum 49 zeigt den RIN-Wert, wenn ein Kohärenzkollaps erreicht ist. Es ist deutlich zu sehen, daß bei Kohärenzkollaps das Signal zu Rauschverhältnis im Bereich niedriger Frequenzen, d. h. unter 0,5 GHz sehr niedrig und konstant ist. Dies ermöglicht bei der Bildaufzeichnung mit einer Bildpunktfrequenz unter 0,5 GHz eine sehr konstante Bildqualität.

Fig. 8 b zeigt den gemessenen Verlauf 50 des NF-Rauschpegels im Bereich 0-10 MHz als Funktion der Zeit. Nach ca. 2 Min. tritt hier der Kohärenzkollaps ein, wodurch der NF-Rauschpegel plötzlich stark um mehr als 25 dB abnimmt. Die stabilisierende Wirkung des Kohärenzkollapses ist dadurch belegt.

Das Prinzip des Kohärenzkollapses läßt sich zur Stabilisierung der Diodenleistung auch in einer Anordnung anwenden, bei der die Laserdiode weitgehend statisch betrieben wird, aber zwischen verschiedenen Leistungen umschaltbar ist. Ein solches System wird zum Beispiel im medizinischen Bereich benötigt, um sogenannte stimulierbare Phosphorfolien, die ein latentes Röntgenbild tragen, mit einem Laserstrahl punktweise anzuregen, um das Röntgenbild auszulesen.

Es wurden Ausführungsbeispiele zum erfindungsgemäßen Betreiben einer Laserdiode im Zustand des Kohärenzkollapses beschrieben. Beispielsweise kann statt den gezeigten externen Glasfaser-Anordnungen bereits innerhalb eines Laserdioden-Moduls ein vollständiges, faseroptisches Auskoppeln vorgesehen werden. Bei derartigen Anordnungen würde sich eine fokussierende Linse erübrigen, die Rückreflexion könnte hier durch einfaches Verspiegeln von Faserenden erfolgen. Auch Kombinationen einzelner Elemente der gezeigten, verschiedenen Ausführungsbeispiele sind ohne weiteres angebbar. Des weiteren ist es ohne weiteres möglich, die angegebenen Verfahren und Vorrichtungen mit anderen, im Stand der Technik bekannten Verfahren und Vorrichtungen zur Stabilisierung von Laserdioden vor mode hops zu kombinieren.

Es hat sich gezeigt, daß sich die oben beschriebene Anordnung mit dem in der deutschen Patentanmeldung 196 07 880.6 beschriebenen und weltweit (u. a. in Japan und den USA) ebenfalls zum Patent angemeldeten Verfahren kombinieren läßt. Dort ist insbesondere beschrieben, die Laserdiode zusätzlich zu einem Einstell- bzw. Modulationssignal mit einem Rauschsignal zu betreiben. Dadurch, daß das Rauschsignal kein determiniertes Signal, sondern ein zufälliges, breitbandiges Signal ist, wird innerhalb der Laserdiode eine Vielzahl von Moden erzeugt. Dies hat zur Folge, daß sich die gesamte Laserlichtenergie auf viele verschiedene Moden gleichmäßig verteilt und führt zu einer wesentlich geringeren Anfälligkeit der Laserdiode, aufgrund von Modensprüngen plötzlich und irregulär hinsichtlich ihrer Lichtleistung zu schwanken. Dabei ist es vorteilhaft, wenn das Rauschsignal eine möglichst hohe Bandbreite im Bereich von einem bis etwa 100 MHz aufweist.

Bei der dort beschriebenen Erfindung ist insbesondere vorgesehen, eine Laserdiode zusätzlich zu einem Intensitäts-Einstellsignal mit einem breitbandigen Bandpaß-Rauschsignal anzusteuern. Das Spektrum dieses nichtperiodischen Zufallssignals ist ein kontinuierliches Spektrum, in dem alle Frequenzen von einer unteren Grenzfrequenz $f_u$ bis zu einer oberen Grenzfrequenz $f_o$ mit gleicher Amplitude auftreten.

Demzufolge weist das Spektrum des rauschmodulierten Laserlichts kontinuierliche Seitenbänder auf, in denen alle Frequenzen gleichmäßig vertreten sind. Aufgrund dieser kontinuierlichen Spektralverteilung existierten auch solche Seitenbandfrequenzen, die mit den Resonanzfrequenzen eines parasitären externen Resonators übereinstimmen. Die aktive Laserdiode verstärkt nun die bei den externen Resonanzfrequenzen vorhandene Energie soweit, daß schließlich bei diesen Frequenzen ungedämpfte Laserschwingungen auftreten. Eine derartige Rauschmodulation bewirkt also, daß die von der Laserdiode erzeugte Lichtleistung gleichmäßig und zeitlich stabil auf eine große Anzahl von Moden des externen Resonators verteilt wird. Das Auftreten von Modensprüngen und der damit verbundenen abrupten Leistungsänderungen wird auf diese Weise weitgehend unterdrückt.

Zur Überlagerung des Einstell- bzw. Modulationssignals (Meßsignal) mit dem Rauschsignal ist dann eine frequenzselektive Überlagerungsschaltung vorgesehen. Sie wirkt für das Nutzsignal als Tießpaßfilter und für das Rauschsignal als Hochpaßfilter. Aus den beiden Signalen bildet die Schaltung vorzugsweise additiv ein Überlagerungssignal, mit dem die Laserdiode angesteuert wird.

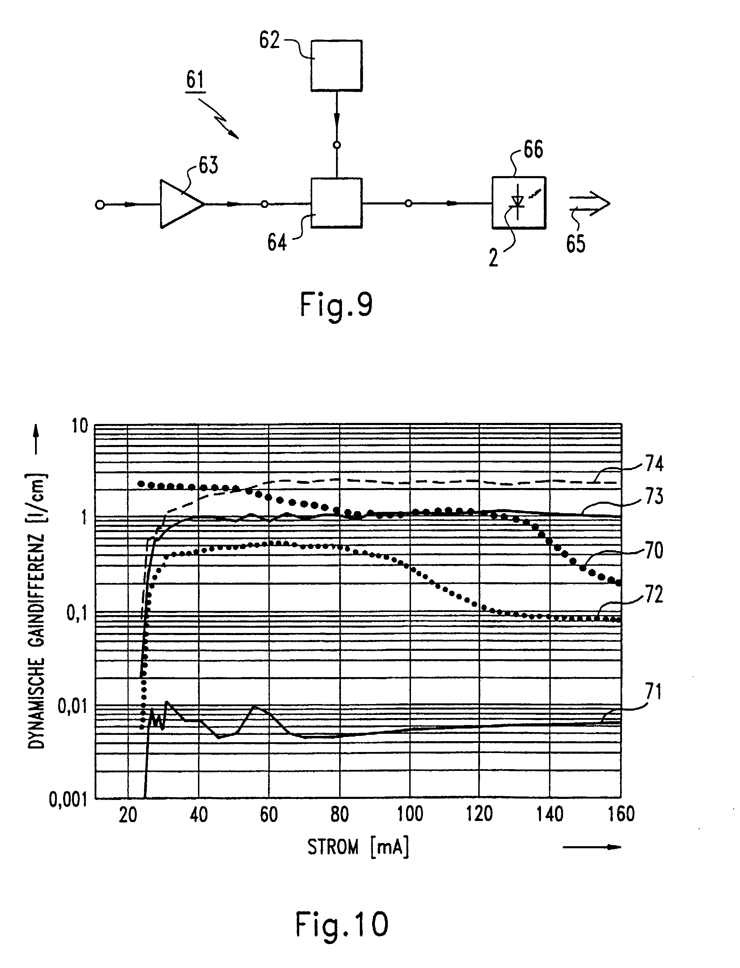

Fig. 9 zeigt eine Variante zur additiven Überlagerung eines Intensitäts-Einstellsignals (Modulations-Bildsignal oder statisches Einstellsignal) mit einem Rauschsignal innerhalb einer im Lasermodul 16 der Figuren 2 oder 3 befindlichen Steuerelektronik 61. Am Bildsignalverstärker 63 ankommende Bild- bzw. Einstellsignale werden dabei einer frequenzselektiven Überlagerungsschaltung 64 zugeführt, die das Bildsignal mit einem von einem Rauschgenerator 62 erzeugten Rauschsignal überlagert. Die Überlagerungsschaltung verhindert dabei eine gegenseitige Beeinflussung der Signalquellen. Das derart überlagerte Signal wird dann im Lasermodul 66 der Laserdiode 2 zugeführt, die den Laserstrahl 65 erzeugt.

Im statischen Zustand der Laserdiode ist die Differenz zwischen der optischen Verstärkung des laseraktiven Mediums und den optischen Verlusten des Laserresonators - die sogenannte Gaindifferenz - gleich Null. Bei hochfrequenten Störungen, deren Frequenzspektrum in der Größenordnung der Eigenresonanz des Lasers liegt, variiert diese Gaindifferenz zeitlich. Der Effektivwert dieser zeitlichen Schwankung - die dynamische Gaindifferenz - ist ein Maß für die Anregung zusätzlicher interner und externer Moden der Laserdiode.

Fig. 10 zeigt die dynamische Gaindifferenz $\Delta g$ in Abhängigkeit vom Strom, der durch eine Laserdiode fließt. Die dynamische Gaindifferenz wird beeinflußt durch die Stärke der optischen Rückkopplung bzw. durch den Effektivwert eines externen Rauschsignals. Sollen Modensprünge wirksam unterdrückt werden, so gilt für externe Modensprünge die Bedingung

$$\Delta g > 0{,}01 \text{ cm}^{-1}$$

und

für interne Modensprünge eines DBR-Lasers die Bedingung

$$\Delta g > 1{,}0 \text{ cm}^{-1}.$$

Die dargestellten Kurvenverläufe sind rechnerisch in einem Modell ermittelt und experimentell bestätigt. Kurve 70 ist das Ergebnis einer breitbandigen Rauschmodulation. Die Kurven 71, 72, 73 und 74 sind das Ergebnis einer optischen Rückkopplung in die Laserdiode, wobei Kurve 71 ein interner Rückkoppelfaktor von $2 \cdot 10^{-7}$, der Kurve 72 von $2 \cdot 10^{-5}$, der Kurve 73 von $2 \cdot 10^{-4}$ und der Kurve 74 von $2 \cdot 10^{-3}$ zugrundeliegt.

Es ist deutlich zu sehen, daß die Rauschmodulation im Bereich niedriger Ströme - d. h. kleiner Lichtintensitäten - Modensprünge wirksamer unterdrückt als eine starke optische Rückkopplung (Kohärenzkollaps), während im Bereich hoher Ströme, d. h. hoher Lichtintensität - eine genügend starke optische Rückkopplung Modensprünge wirksamer unterdrückt als die Rauschmodulation.

Durch die in der DE 196 07 880.6 näher beschriebene Methode der Rauschmodulation wird ohne spezielle Abstimmungsmaßnahmen sichergestellt, daß eine optimale Unterdrückung von Modensprüngen erfolgt. Dies gilt auch für den Fall, daß mehrere externe Resonatoren mit verschiedenen Modensprüngen vorhanden sind, solange die jeweiligen Resonanzfrequenzen innerhalb der Bandbreite des optischen Spektrums liegen. Des weiteren ist durch die Überlagerung des Einstellsignals mit dem Rauschsignal die nutzbare Lichtleistung im Vergleich zu anderen, bereits bekannten, austastenden Verfahren des Standes der Technik relativ groß.

Im Falle eines Halbleiterlasers ist die Bandbreite des optischen Spektrums wesentlich größer als die doppelte Bandbreite des Rauschsignals, da bei der direkten Modulation von Halbleiterlasern neben einer Amplitudenmodulation (AM) auch eine starke Frequenzmodulation (FM) auftritt. Die Bandbreite B des optischen Spektrums wird durch die sogenannte Frequenzmodulations-Steilheit $S_{FM}$ der Laserdiode und durch den Effektivwert $I_{eff}$ des Rauschstroms festgelegt:

$$B = S_{FM} \cdot I_{eff} \qquad (B3).$$

Aufgrund dieses Zusammenhangs läßt sich eine einfache Bedingung für die wirkungsvolle Unterdrückung von Modensprüngen mittels Rauschmodulation angeben: Ist $L_{ext}$ der Abstand zwischen der Laserdiode und der ersten optisch wirksamen Fläche (Reflexionsstelle), dann ist zur Unterdrückung von Modensprüngen ein Rauschstrom mit dem Effektivwert

$$I_{eff} > \frac{c}{S_{FM} \cdot L_{ext}} \qquad (B4)$$

besonders vorteilhaft. Bei dieser Dimensionierung werden auch alle Modensprünge unterdrückt, die von weiter entfernt liegenden Reflexionsstellen hervorgerufen werden. Die FM-Steilheit von Laserdioden liegt normalerweise im Bereich von $S_{FM} = 100$ MHz/mA bis $S_{FM} = 500$ MHz/mA. Bei einem typischen Wert von $S_{FM} = 200$ MHz/mA ist z. B. für einen 30 cm langen Resonator ein Rauschstrom mit einem Effektivwert von mindestens 5 mA besonders wirkungsvoll. Da der Effektivwert einer Rauschgröße proportional zur Wurzel aus dem Produkt von Bandbreite und spektraler Leistungsdichte ist, kann zur Rauschmodulation sowohl breitbandiges Rauschen mit niedriger Leistungsdichte als auch schmalbandigeres Rauschen mit höherer Leistungsdichte verwendet werden. Diese Tatsache wird durch eine experimentelle Untersuchung bestätigt, bei der unabhängig von der Rauschbandbreite (6 MHz bzw. 50 MHz) die Unterdrückung des Modenspringens bei einem effektiven Rauschstrom ca. 5 mA auftrat.

Durch die Kombination des zuerst beschriebenen Verfahrens des Kohärenzkollapses mit dem zuletzt beschriebenen Verfahren der Rauschmodulation läßt sich ein für Anwendungen in den Bereichen der Bildabtastung, der Bildübertragung und der Bildaufzeichnung entscheidender Vorteil erreichen. Insgesamt ergibt sich dann eine gleichmäßig gute Unterdrückung von Mode Hops über den gesamten, nutzbaren Leistungsbereich der Laserdiode.

**Patentansprüche**

**1.** Verfahren zum Betreiben einer Laserdiode (2) deren Laserstrahl (9) mittels eines Einstellsignals hinsichtlich seiner Intensität moduliert und über einen ersten Strahlengang (10) auf eine zu belichtende Nutzfläche (5) gerichtet wird wobei bezüglich der Laserdiode (2) zeitlich und/oder räumlich instabile Störreflexe von der als Reflektor wirkenden Nutzfläche (5) auf die Laserdiode (2) wirken, **dadurch gekennzeichnet**, daß mittels eines eine gezielte, kontrollierbare Rückkopplung bewirkenden und zeitlich und bezüglich der Laserdiode räumlich stabilen Elements (19, 28, 31, 37, 38) ein derart hoher Teil des aus der Laserdiode (2) ausgetretenen Lichts über einen zusatzlicnen zweiten Strahlengang (11) in die aktive Zone (42) der Laserdiode (2) zurückgekoppelt wird, daß sich die Laserdiode (2) im Zustand eines Kohärenzkollaps befindet.

**2.** Verfahren nach Anspruch 1, dadurch gekennzeichnet, daß die Rückkopplung mit faseroptischen Mitteln (37, 38) erfolgt.

3. Verfahren nach Anspruch 1 oder 2, dadurch gekennzeichnet, daß die Rückkopplung mit reflektierenden optischen Mitteln (19, 28) erfolgt.

4. Verfahren nach einem der vorhergehenden Ansprüche, dadurch gekennzeichnet, daß der Laserstrahl (9) in einen Nutzstrahl (10) und einen Rückkoppelstrahl (11) aufgetrennt wird und daß der Rückkoppelstrahl (11) in die Laserdiode (2) zurückgekoppelt wird.

5. Verfahren nach Anspruch 4, dadurch gekennzeichnet, daß der Rückkoppel-strahl (11) erzeugt wird, indem das aus der Laserdiode (21) ausgetretene Licht an einer Reflexions-Oberfläche (12) reflektiert wird und daß der reflektierte Strahl (11) zumindest teilweise auf demselben optischen Weg in die Laserdiode (2) zurückreflektiert wird, auf dem das Licht ausgetreten ist.

6. Verfahren nach Anspruch 4 oder 5, dadurch gekennzeichnet, daß der Laserstrahl (9) oder der Rückkoppelstrahl (11) auf eine, insbesondere teilweise reflektierende, Reflexions-Oberfläche (20, 28) fokussiert wird.

7. Verfahren nach einem der Ansprüche 1 bis 6, dadurch gekennzeichnet, daß der Laserstrahl (9) oder der Rückkoppelstrahl (11) als paralleles Strahlenbündel zumindest teilweise in sich selbst zurückreflektiert wird.

8. Verfahren nach einem der vorhergehenden Ansprüche, dadurch gekennzeichnet, daß zumindest 1 % der aus der Laserdiode (2) austretenden Lichtleistung zurückgekoppelt wird.

9. Verfahren nach einem der vorhergehenden Ansprüche, dadurch gekennzeichnet, daß die optische Weglänge des rückgekoppelten Lichtes außerhalb der aktiven Zone (42) der Laserdiode (2) mindestens 100 mm beträgt.

10. Verfahren nach einem der vorhergehenden Ansprüche, dadurch gekennzeichnet, daß das zurückgekoppelte Licht derart in die aktive Zone (42) der Laserdiode (2) eingekoppelt wird, daß seine Querschnittsfläche (44) eine Querschnittsfläche (43) des emittierten Lichtstrahls mindestens zu 50% überdeckt.

11. Verfahren nach einem der vorhergehenden Ansprüche, dadurch gekennzeichnet, daß das Einstellsignal ein Modulationssignal ist, wodurch die Laserdiode (2) in ihrer Helligkeit moduliert wird.

12. Verfahren nach einem der vorhergehenden Ansprüche, dadurch gekennzeichnet, daß mit dem modulierten Licht eine Bildaufzeichnung oder eine Bildabtastung, insbesondere auf fotografischem Material oder auf einer stimulierbaren Phosphorspeicherfolie erfolgt.

13. Vorrichtung zum Betreiben einer Laserdiode (2) deren Laserstrahl (9) im Betrieb mittels eines Einstellsignals hinsichtlich seiner Intensität moduliert und über einen ersten Strahlengang (10) auf eine zu belichtende Nutzfläche (5) gerichtet wird, wobei bezüglich der Laserdiode (2) zeitlich und/oder räumlich unstabile Störreflexe von der als Reflektor wirkenden Nutzfläche (5) auf die Laserdiode (2) wirken, gekennzeichnet durch ein zeitlich und bezüglich der Laserdiode räumlich stabiles Kopplungselement (19, 28, 31, 37, 38), das einen Teil des aus der Laserdiode (2) ausgetretenen Lichts über einen zusätzlichen zweiten Strahlengang (11) gezielt zu einem derart hohen Anteil wieder in die aktive Zone (42) der Laserdiode (2) derart zurückkoppelt, daß sich die Laserdiode (2) im Zustand eines Kohärenzkollaps befindet.

14. Vorrichtung nach Anspruch 13, dadurch gekennzeichnet, daß das Kopplungsmittel (4) eine Lichtfaseranordnung (7) umfaßt.

15. Vorrichtung nach Anspruch 13 oder 14, dadurch gekennzeichnet, daß das Kopplungsmittel (4) reflektierende optische Elemente (12, 28) umfaßt.

16. Vorrichtung nach einem der Ansprüche 13 bis 15, dadurch gekennzeichnet, daß Mittel vorgesehen sind, die den Laserstrahl (9) in einen Rückkoppelstrahl (11) und in einen Nutzstrahl (10) aufteilen, wobei der Rückkoppelstrahl (11) in die aktive Zone der Laserdiode (2) zurückgekoppelt wird.

17. Vorrichtung nach einem der Ansprüche 15 oder 16, dadurch gekennzeichnet, daß Fokussierungsmittel (30) vorgesehen sind, die den Laserstrahl (9) oder den Reflexstrahl (11) auf den Reflexionsmitteln (28) fokussieren.

18. Vorrichtung nach einem der Ansprüche 13 bis 17, dadurch gekennzeichdaß Verstellmittel (23) für die Laserdiode (2) vorgesehen sind, mit denen die Laserdiode (2) axial und/oder lateral zur optischen Achse (B) verstellbar ist.

19. Vorrichtung nach einem der Ansprüche 15 bis 18, dadurch gekennzeichnet, daß Verstellmittel (31) vorgesehen sind, mit denen das Reflexionsmittel (31) axial und/oder lateral zur optischen Achse (B) verstellbar ist.

**20.** Vorrichtung nach einem der Ansprüche 13 bis 19, dadurch gekennzeichnet, daß Mittel (64) vorgesehen sind, mit denen ein Modulationssignal als Einstellsignal übertragbar ist.

**21.** Vorrichtung nach einem der Ansprüche 15 bis 20, dadurch gekennzeichnet, daß als zweiter Reflektor (12, 28) eine Fotodiode vorgesehen ist.

**22.** Vorrichtung nach einem der Ansprüche 15 bis 21, dadurch gekennzeichnet, daß der zweite Reflektor (12, 28) auf dem zweiten optischen Strahlengang (11) mindestens 100 mm vom Austrittsfenster der Laserdiode (2) entfernt ist.

**23.** Vorrichtung nach einem der Ansprüche 13 bis 22 mit einer Schaltung zur Intensitäts-Einstellung, insbesondere zur Modulation eines durch eine Laserdiode (2) erzeugten Laserstrahls (12, 15) mittels eines Einstellsignals, dadurch gekennzeichnet, daß Mittel (62) zum Erzeugen eines Rauschsignals und Mittel (64) zum Ansteuern der Laserdiode (2) mit einem aus dem Rauschsignal und dem Einstellsignal überlagterten Signal vorgesehen sind.

**Claims**

**1.** Method for operating a laser diode (2) whose laser beam (9) is modulated in its intensity by means of an adjusting signal and is directed via a first beam path (10) onto a useful surface (5) to be illuminated, wherein unwanted reflections from the useful surface (5) acting as reflector, which reflections are unstable in time and/or in space in relation to the laser diode (2), act on the laser diode (2), characterized in that, by means of an element (19, 28, 31, 37, 38) which effects a selective,
controllable feedback and is stable in time and spatially stable in relation to the laser diode, such a high proportion of the light which has emerged from the laser diode (2) is coupled back via an additional second beam path (11) into the active zone (42) of the laser diode (2) that the laser diode (2) is in the state of a coherent collapse.

**2.** Method according to Claim 1, characterized in that the feedback takes place with fibre-optic means (37, 38).

**3.** Method according to Claim 1 or 2, characterized in that the feedback takes place with reflecting optical means (19, 28).

**4.** Method according to one of the preceding claims, characterized in that the laser beam (9) is separated into a useful beam (10) and a feedback beam (11) and in that the feedback beam (11) is coupled back into the laser diode (2).

**5.** Method according to Claim 4, characterized in that the feedback beam (11) is generated by light which has emerged from the laser diode (21) being reflected at a reflection surface (12) and in that the reflected beam (11) is reflected back at least partly over the same optical path into the laser diode (2) over which the light emerged.

**6.** Method according to Claim 4 or 5, characterized in that the laser beam (9) or the feedback beam (11) is focused on a reflection surface (20, 28), in particular a partly reflecting reflection surface (20, 28).

**7.** Method according to one of Claims 1 to 6, characterized in that the laser beam (9) or the feedback beam (11) is reflected back at least partly into itself as a parallel beam bundle.

**8.** Method according to one of the preceding claims, characterized in that at least 1% of the light power emerging from the laser diode (2) is fed back.

**9.** Method according to one of the preceding claims, characterized in that the optical path length of the fed-back beam outside the active zone (42) of the laser diode (2) is at least 100 mm.

**10.** Method according to one of the preceding claims, characterized in that the fed-back light is coupled into the active zone (42) of the laser diode (2) in such a way that its cross-sectional area (44) covers at least 50% of the cross section (43) of the emitted light beam.

**11.** Method according to one of the preceding claims, characterized in that the adjusting signal is a modulation signal which modulates the brightness of the laser diode (2).

**12.** Method according to one of the preceding claims, characterized in that an image is recorded or scanned with the modulated light, in particular on photographic material or on a stimulable phosphor storage film.

**13.** Device for operating a laser diode (2) whose laser beam (9) is modulated in its intensity during operation by means of an adjusting signal and is directed via a first beam path (10) onto a useful surface (5) to be illuminated, wherein unwanted reflections from the useful surface (5) acting as reflector, which reflections are unstable in time and/or space in relation to the laser diode (2), act on the laser diode (2), characterized by a coupling element (19, 28, 31, 37, 38) which is stable in time and spatially stable in relation to the laser diode and which feeds back again a portion of the light which has emerged from the laser diode (2) via an additional second beam path (11) in a selective manner to such a high proportion into the active zone (42) of the laser diode (2) that the laser diode (2) is in the state of a coherent collapse.

14. Device according to Claim 13, characterized in that the coupling means (4) comprises an optical fibre arrangement (7).

15. Device according to Claim 13 or 14, characterized in that the coupling means (4) comprises reflecting optical elements (12, 28).

16. Device according to one of Claims 13 to 15, characterized in that means are provided which split the laser beam (9) into a feedback beam (11) and into a useful beam (10), wherein the feedback beam (11) is fed back into the active zone of the laser diode (2).

17. Device according to one of Claims 15 or 16, characterized in that focusing means (30) are provided which focus the laser beam (9) or the reflected beam (11) on the reflection means (28).

18. Device according to one of Claims 13 to 17, characterized in that adjustment means (23) are provided for the laser diode (2) with which the laser diode (2) can be adjusted axially and/or laterally in relation to the optical axis (B) .

19. Device according to one of Claims 15 to 18, characterized in that adjustment means (31) are provided with which the reflection means (31) can be adjusted axially and/or laterally in relation to the optical axis (B).

20. Device according to one of Claims 13 to 19, characterized in that means (64) are provided with which a modulation signal can be transmitted as adjusting signal.

21. Device according to one of Claims 15 to 20, characterized in that a photodiode is provided as second reflector (12, 28).

22. Device according to one of Claims 15 to 21, characterized in that the second reflector (12, 28) on the second optical beam path (11) is at least 100 mm away from the exit window of the laser diode (2).

23. Device according to one of Claims 13 to 22 comprising a circuit for the intensity adjustment, in particular for the modulation of a laser beam (12, 15) generated by a laser diode (2) by means of an adjusting signal,
characterized in that means (62) are provided for generating a noise signal and means (64) are provided for driving the laser diode (2) with a signal superimposed from the noise signal and the adjusting signal.

## Revendications

1. Procédé de commande d'une diode laser (2), dont le faisceau laser (9) est modulé, au moyen d'un signal de réglage, quant à son intensité, et est dirigé par l'intermédiaire d'un premier chemin de rayonnement (10) sur une surface utile (5) à exposer, et dans lequel des reflets parasites, instables dans le temps et/ou dans l'espace par rapport à la diode laser (2), et provenant de la surface utile (5) agissant en tant que réflecteur, agissent sur la diode laser (2), caractérisé en ce que, à l'aide d'un élément (19, 28, 31, 37, 38), stable dans le temps et, par rapport à la diode laser, stable dans l'espace, adapté à produire une rétroaction appropriée et contrôlable, une partie de la lumière, émise à partir de la diode laser (2), est réinjectée, par l'intermédiaire d'un deuxième chemin de rayonnement (11) supplémentaire, dans la zone active (42) de la diode laser (2) et ce, en une quantité telle que la diode laser (2) se trouve dans un état d'effondrement de cohérence.

2. Procédé selon la revendication 1, caractérisé en ce que la rétroaction s'effectue par des moyens à fibres optiques (37, 38).

3. Procédé selon la revendication 1 ou 2, caractérisé en ce que la rétroaction s'effectue par des moyens optiques réfléchissants (19, 28).

4. Procédé selon l'une des revendications précédentes, caractérisé en ce que le faisceau laser (9) est divisé en un faisceau utile (10) et en un faisceau de rétroaction (11) et en ce que le faisceau de rétroaction (11) est réinjecté dans la diode laser (2).

5. Procédé selon la revendication 4, caractérisé en ce que le faisceau de rétroaction (11) est produit par une réflexion de la lumière, émise à partir de la diode laser (21), sur une surface de réflexion (12) et en ce que le faisceau réfléchi (11) est renvoyé jusque dans la diode laser (2), au moins en partie sur le même chemin optique que celui sur lequel la lumière a été émise.

6. Procédé selon la revendication 4 ou 5, caractérisé en ce que le faisceau laser (9) ou le faisceau de rétroaction (11) est focalisé sur une surface de réflexion (20, 28), notamment partiellement réflectrice.

**7.** Procédé selon l'une des revendications -1 à 6, caractérisé en ce que le faisceau laser (9) ou le faisceau de rétroaction (11) est réfléchi, du moins en partie en lui-même en tant que faisceau de rayons parallèle.

**8.** Procédé selon l'une des revendications précédentes, caractérisé en ce qu'au moins 1 % du flux lumineux, émis à partir de la diode laser (2), est réinjecté.

**9.** Procédé selon l'une des revendications précédentes, caractérisé en ce que la longueur du chemin optique de la lumière de rétroaction est d'au moins 100 mm, à l'extérieur de la zone active (42) de la diode laser (2).

**10.** Procédé selon l'une des revendications précédentes, caractérisé en ce que la lumière réinjectée est amenée dans la zone active (42) de la diode laser (2) de telle manière que son aire de section transversale (44) recouvre au moins à 50 % une aire de section transversale (43) du faisceau lumineux émis.

**11.** Procédé selon l'une des revendications précédentes, caractérisé en ce que le signal de réglage est un signal de modulation, permettant de moduler la diode laser (2) quant à son intensité lumineuse.

**12.** Procédé selon l'une des revendications précédentes, caractérisé en ce que la lumière modulée sert à enregistrer une image ou à explorer une image, notamment sur une matière photographique ou sur une feuille à effet de mémoire de luminophore, propre à être stimulée.

**13.** Dispositif de commande d'une diode laser (2), dont le faisceau laser (9) est modulé en fonctionnement, au moyen d'un signal de réglage, quant à son intensité, et est dirigé, par l'intermédiaire d'un premier chemin de rayonnement (10) sur une surface utile (5) à exposer, et dans lequel des reflets parasites, instables dans le temps et/ou dans l'espace, par rapport à la diode laser (2), et provenant de la surface utile (5) agissant en tant que réflecteur, agissent sur la diode laser (2), caractérisé par un élément de couplage(19, 28, 31, 37, 38), stable dans le temps et, par rapport à la diode laser, stable dans l'espace, qui réinjecte une partie de la lumière, émise à partir de la diode laser (2), par l'intermédiaire d'un deuxième chemin de rayonnement (11) supplémentaire, de nouveau dans la zone active (42) de la diode laser (2) et ce, en une quantité telle que la diode laser (2) se trouve dans un état d'effondrement de cohérence.

**14.** Dispositif selon la revendication 13, caractérisé en ce que le moyen de couplage (4) comprend un agencement à fibres optiques (7).

**15.** Dispositif selon la revendication 13 ou 14, caractérisé en ce que le moyen de couplage (4) comprend des éléments optiques réfléchissants (12, 28).

**16.** Dispositif selon l'une des revendications 13 à 15, caractérisé en ce que des moyens sont prévus pour diviser le faisceau laser (9) en un faisceau de rétroaction (11) et en un faisceau utile (10), le faisceau de rétroaction (11) étant réinjecté dans la zone active de la diode laser (2).

**17.** Dispositif selon la revendication 15 ou 16, caractérisé en ce qu'il est prévu des moyens de focalisation (30), qui concentrent le faisceau laser (9) ou le faisceau de réflexion (11) sur les moyens de réflexion (28).

**18.** Dispositif selon l'une des revendications 13 à 17, caractérisé en ce qu'il est prévu des moyens de déplacement (23) pour la diode laser (2), à l'aide desquels la diode laser (2) peut être déplacée axialement et/ou latéralement par rapport à l'axe optique (B).

**19.** Dispositif selon l'une des revendications 15 à 18, caractérisé en ce qu'il est prévu des moyens de déplacement (31), à l'aide desquels le moyen de réflexion (31) peut être déplacé axialement et/ou latéralement par rapport à l'axe optique (B).

**20.** Dispositif selon l'une des revendications 13 à 19, caractérisé en ce qu'il est prévu des moyens (64), à l'aide desquels un signal de modulation peut être transmis, en tant que signal de réglage.

**21.** Dispositif selon l'une des revendications 15 à 20, caractérisé en ce qu'il est prévu, en tant que deuxième réflecteur (12, 28), une photodiode.

**22.** Dispositif selon l'une des revendications 15 à 21, caractérisé en ce que le deuxième réflecteur (12, 28) est situé, sur le deuxième chemin de rayonnement optique (11), à une distance d'au moins 100 mm de la fenêtre de sortie de la diode laser (2).

**23.** Dispositif selon l'une des revendications 13 à 22, comportant un circuit pour le réglage de l'intensité, notamment pour la modulation d'un faisceau laser (12, 15) produit par une diode laser (2) à l'aide d'un signal de réglage, caractérisé en ce qu'il est prévu des moyens (62) pour la génération d'un signal de bruit et des moyens (64) pour l'attaque de la diode laser (2) par un signal résultant de la superposition du signal de bruit et du signal de réglage.

Fig.1

Fig.2a

Fig.2b

Fig.2c

Fig.2d

Fig.3a

Fig.3b

Fig.3c

Fig.3d

Fig.4

Fig.5

Fig.6

Fig.7a

FSR

ΔT

I

45

Fig.7b

46

Δf

47

Fig.7c

f

Zeit

Fig.8a

Fig.8b

Fig.9

Fig.10